# EUROPEAN PATENT SPECIFICATION

(11) **EP 3 768 052 B1**
(45) Date of publication and mention of the grant of the patent: **24.01.2024**
(21) Application number: 19767031.8
(22) Date of filing: 01.02.2019
(51) Int. Cl.: H04N 23/00, G02B 13/16, G02B 7/02, H04N 23/51, H04N 23/54, H05K 1/02

(54) **SECURING STRUCTURE, ELECTRONIC DEVICE, IMAGING DEVICE, MOVING BODY, AND SECURING STRUCTURE PRODUCTION METHOD**
SICHERUNGSSTRUKTUR, ELEKTRONISCHE VORRICHTUNG, BILDGEBUNGSVORRICHTUNG, BEWEGLICHER KÖRPER UND SICHERUNGSSTRUKTURHERSTELLUNGSVERFAHREN
STRUCTURE DE FIXATION, DISPOSITIF ÉLECTRONIQUE, DISPOSITIF D'IMAGERIE, CORPS MOBILE ET PROCÉDÉ DE PRODUCTION DE STRUCTURE DE FIXATION

(30) Priority: 13.03.2018 JP 2018045769
(43) Date of publication of application: 20.01.2021
(73) Proprietor: Kyocera Corporation, Kyoto-shi, Kyoto 612-8501 (JP)
(72) Inventor: YASUDA, Toshiyuki, Kyoto-shi, Kyoto 612-8501 (JP)
(74) Representative: Viering, Jentschura & Partner mbB Patent- und Rechtsanwälte
(86) International application number: PCT/JP2019/003715
(87) International publication number: WO 2019/176363

(56) References cited:
- WO-A1-2014/010074
- WO-A1-2017/187690
- WO-A1-2017/187690
- JP-A- 2000 252 652
- JP-A- 2007 150 708
- JP-A- 2014 017 435
- US-A1- 2010 208 564

## Description

### CROSS REFERENCE TO RELATED APPLICATION

This application claims priority to and the benefit of Japanese Patent Application No. 2018-45769 filed on March 13, 2018.

### TECHNICAL FIELD

The present disclosure relates to a fixing structure, an electronic apparatus, an imaging apparatus, a moveable body, and a fixing structure manufacturing method.

### BACKGROUND

Fixing structures that can precisely align and fix a plate-like member in a housing, such as a structure in which a circuit board carrying an image sensor is fixed to a housing holding an optical system, have conventionally been studied. Not only precise alignment but also simplified manufacture is required. To achieve precise alignment with simplified manufacture, a technique of performing alignment in a state in which a protrusion and a notch with a gap therebetween are loosely fitted and fixing members using an adhesive is proposed (see JP 2004-010759 A (PTL 1)).
Moreover, US 2010/208564 A1 discloses a support holder for holding an optical detector and an optical base for fixing the support holder, wherein the support holder has at least two notches at its both ends, the optical base has convex portions corresponding to the notches of the support holder, and the optical base and the support holder are fixed by photo-curable adhesives for bonding the convex portions and the support holder to each other; and WO 2017/187690 A1 discloses a bonding structure for fixing a plate member inside a housing storing the plate member, the bonding structure including an opening, a fixing portion, adhesive, and a transmissive portion.

### CITATION LIST

### Patent Literature

PTL 1: JP 2004-010759 A

### SUMMARY

The present invention provides a fixing structure according to claim 1, an electronic apparatus according to claim 6, an imaging apparatus according to claim 7, a moveable body according to claim 8, and a fixing structure manufacturing method according to claim 9. Preferred embodiments are described in the dependent claims.

### BRIEF DESCRIPTION OF THE DRAWINGS

In the accompanying drawings:
FIG. 1 is a diagram illustrating a mounting position, in a moveable body, of an imaging apparatus using a fixing structure according to an embodiment;
FIG. 2 is a sectional diagram illustrating a schematic configuration of the imaging apparatus in FIG. 1, taken along an optical axis;
FIG. 3 is an enlarged sectional diagram illustrating a schematic configuration of the fixing structure in FIG. 2;
FIG. 4 is a perspective diagram illustrating the appearance of a protrusion in FIG. 3;
FIG. 5 is a sectional diagram illustrating a section of the protrusion in FIG. 4 perpendicular to its protruding direction;
FIG. 6 is a sectional diagram illustrating a section of a modification of the protrusion in FIG. 4 perpendicular to its protruding direction, in a configuration in which an engaging portion is a notch;
FIG. 7 is a perspective diagram illustrating the appearance of another example of the protrusion in FIG. 3;
FIG. 8 is a perspective diagram illustrating the appearance of another example of the protrusion in FIG. 3;
FIG. 9 is a perspective diagram illustrating the appearance of another example of the protrusion in FIG. 3;
FIG. 10 is a sectional diagram illustrating a manufacturing method for the fixing structure in FIG. 3, and illustrating a support posture of a housing;
FIG. 11 is a sectional diagram illustrating the manufacturing method for the fixing structure in FIG. 3, and illustrating a state in which rough alignment of a plate-like member has been performed in the housing;
FIG. 12 is a sectional diagram illustrating the manufacturing method for the fixing structure in FIG. 3, and illustrating a state in which precise alignment of the plate-like member has been performed in the housing;
FIG. 13 is a sectional diagram illustrating the manufacturing method for the fixing structure in FIG. 3, and illustrating a state in which an injector has been inserted into a recess;
FIG. 14 is a sectional diagram illustrating the manufacturing method for the fixing structure in FIG. 3, and illustrating a state in which injection of an adhesive into the recess has started;
FIG. 15 is a sectional diagram illustrating the manufacturing method for the fixing structure in FIG. 3, and illustrating a state in which the injected adhesive has reached an engaging portion; and
FIG. 16 is a top diagram illustrating an operation necessary when manufacturing a conventional fixing structure.

### DETAILED DESCRIPTION

An embodiment of a fixing structure to which the present disclosure is applied will be described below, with reference to the drawings.

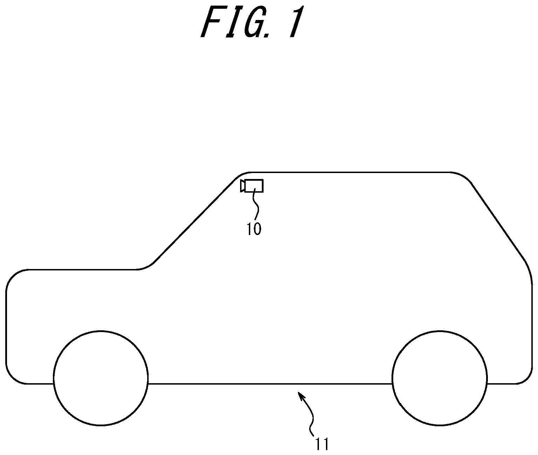

A fixing structure according to one of the disclosed embodiments is used, for example, in an electronic apparatus. A specific example of the electronic apparatus is an imaging apparatus. For example, an imaging apparatus 10 using the fixing structure according to this embodiment is mounted in a moveable body 11, as illustrated in FIG. 1.

The moveable body 11 may be, for example, a vehicle, a ship, or an aircraft. Vehicles may include, for example, motor vehicles, industrial vehicles, railed vehicles, domestic vehicles, and fixed-wing airplanes running on runways. Motor vehicles may include, for example, cars, trucks, buses, two-wheeled vehicles, and trolleybuses. Industrial vehicles may include, for example, industrial vehicles for agriculture and construction. Industrial vehicles may include, for example, forklifts and golf carts. Industrial vehicles for agriculture may include, for example, tractors, cultivators, transplanters, binders, combines, and lawn mowers. Industrial vehicles for construction may include, for example, bulldozers, scrapers, power shovels, crane trucks, dump trucks, and road rollers. Vehicles may include human-powered vehicles. The classifications of vehicles are not limited to the above-mentioned examples. For example, motor vehicles may include industrial vehicles that can run on roads. The same type of vehicle may belong to a plurality of classifications. Ships may include, for example, personal watercraft, boats, and tankers. Aircraft may include, for example, fixed-wing airplanes and rotary-wing airplanes.

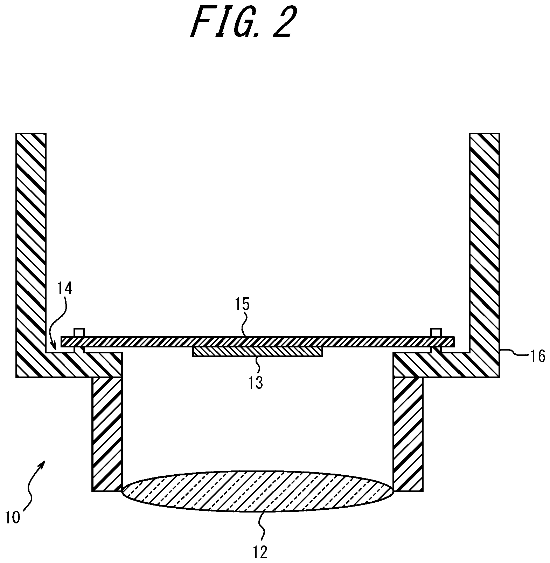

The imaging apparatus 10 includes an optical system 12, an image sensor 13, and a fixing structure 14, as illustrated in FIG. 2.

The optical system 12 includes an optical element such as a lens. The optical system 12 is designed so that its optical properties such as angle of view and depth of field will be desired values, and formed. The optical system 12 forms a subject image. The optical system 12 is held by a housing 16 included in the below-described fixing structure 14.

The image sensor 13 is, for example, a charge coupled device (CCD) image sensor or a complementary metal oxide semiconductor (CMOS) image sensor. The image sensor 13 is mounted on a circuit board that is a plate-like member 15 included in the below-described fixing structure 14. The image sensor 13 is located at an image formation position of the optical system 12, via the plate-like member 15 and the housing 16. The image sensor 13 captures the subject image formed by the optical system 12.

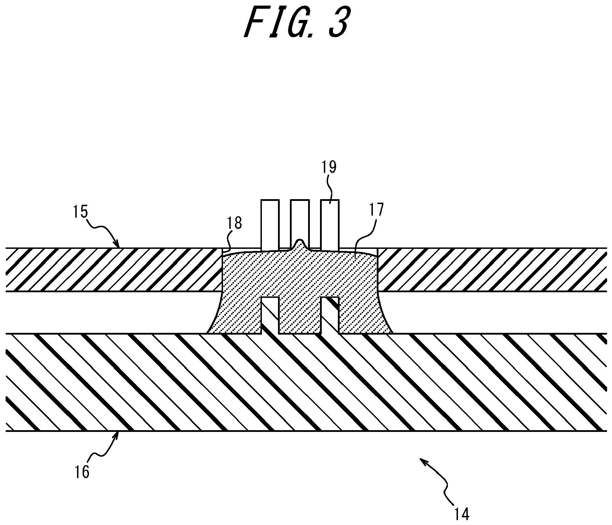

The fixing structure 14 includes the plate-like member 15, the housing 16, and an adhesion body 17, as illustrated in FIG. 3.

The plate-like member 15 is, for example, a circuit board, as mentioned above. The plate-like member 15 has an engaging portion 18 in part of its plate surface. The engaging portion 18 may include, for example, at least one of a through hole from one plate surface to the other plate surface and a notch from an end at a plate surface. For example, the whole engaging portion 18 may be a through hole, the whole engaging portion 18 may be a notch, or the engaging portion 18 may be a through hole in one part and a notch in another part.

The housing 16 has a protrusion 19 at a position at which the plate-like member 15 is fixed. The protrusion 19 is, for example, a boss that is cylindrical as a whole. For example, the protrusion 19 protrudes perpendicularly to the inner wall surface of the housing 16 and inwardly, inside the housing 16 in which the plate-like member 15 is provided. More specifically, the protrusion 19 protrudes in parallel with the optical axis direction of the optical system 12 held by the housing 16, in a direction away from the optical system 12. The protrusion 19 is provided so that the plate-like member 15 can be located substantially at a predetermined position with respect to the housing 16 in a state in which the protrusion 19 and the engaging portion 18 of the plate-like member 15 are loosely fitted together. The outer diameter of the protrusion 19 is smaller than the inner diameter of the engaging portion 18 of the plate-like member 15. In a state in which the protrusion 19 is inserted in the engaging portion 18, a gap can be formed between the outer peripheral wall surface of the protrusion 19 and the inner peripheral wall surface of the engaging portion 18.

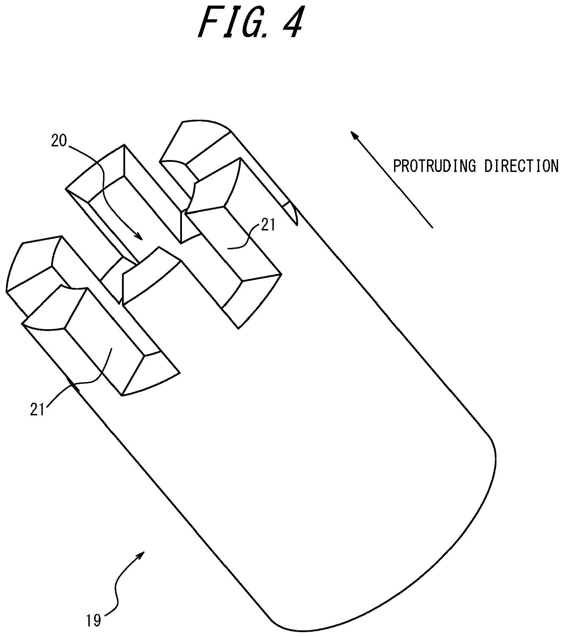

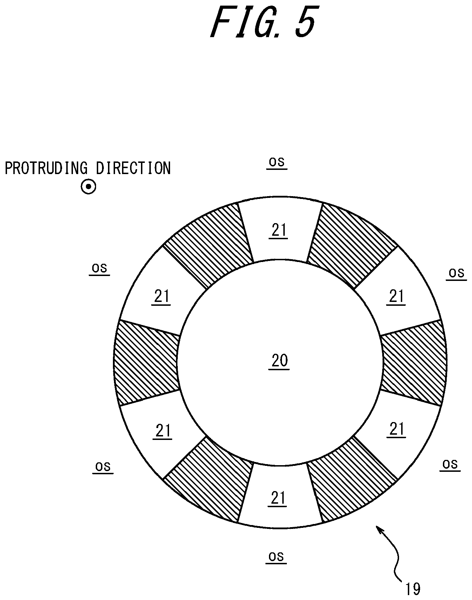

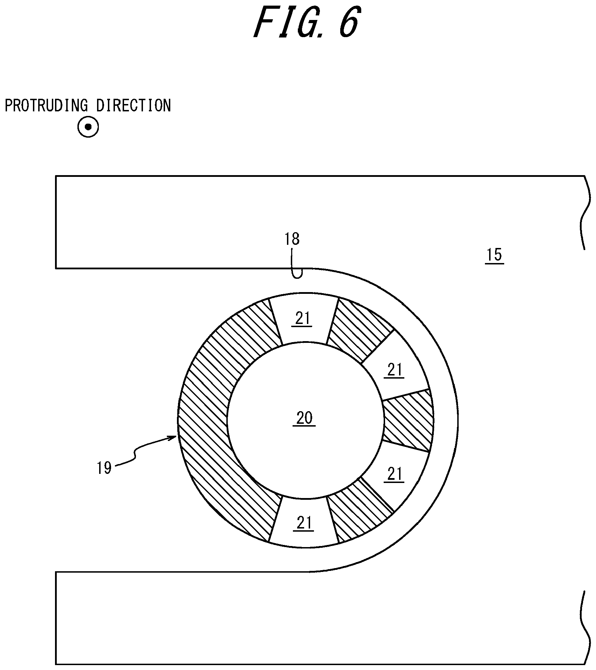

As illustrated in FIG. 4, the protrusion 19 has a recess 20 formed from the tip along the protruding direction. The protrusion 19 has a plurality of communicating portions 21. As illustrated in FIG. 5, each communicating portion 21 communicates between the recess 20, i.e. the internal space, of the protrusion 19 in the part having the recess 20 and the outer periphery of the protrusion 19, i.e. the surrounding space os outside the peripheral wall defining the recess 20. The plurality of communicating portions 21 are distributed around an axis extending in the protruding direction. The axis extending in the protruding direction is an axis passing through the center of gravity of the protrusion 19 in a section perpendicular to the protruding direction. The plurality of communicating portions 21 may or may not be arranged at equal intervals around the axis extending in the protruding direction. In this embodiment, the plurality of communicating portions 21 are arranged at equal intervals around the axis extending in the protruding direction. In a configuration in which the engaging portion 18 is a notch, the communicating portions 21 may be located only in a part facing the inner peripheral wall defining the engaging portion 18, as illustrated in FIG. 6.

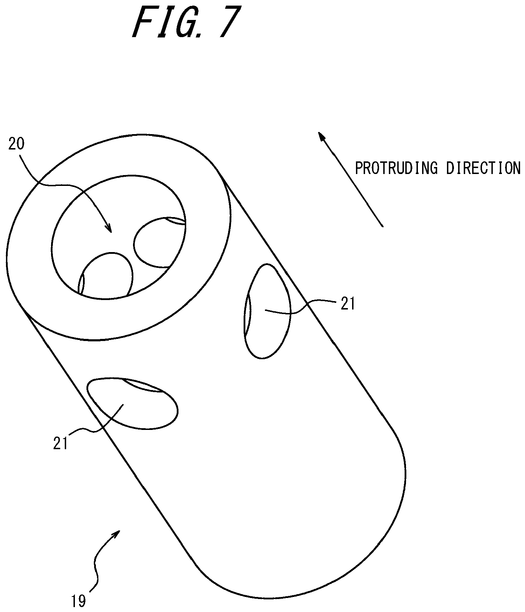

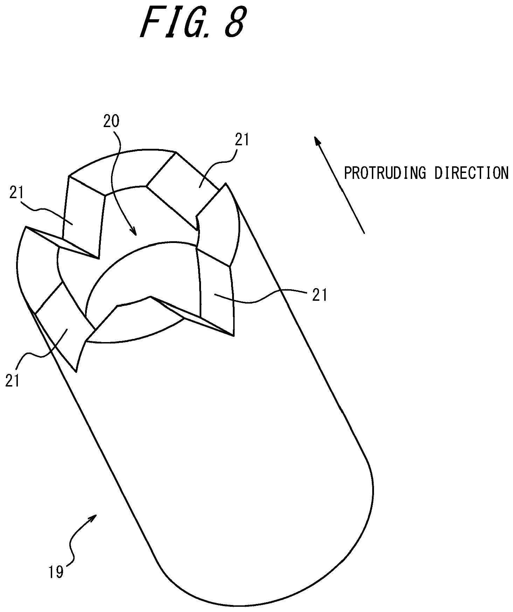

For example, each communicating portion 21 may have a shape of a slit extending from the tip of the protrusion 19 along the protruding direction, as illustrated in FIG. 4. For example, each communicating portion 21 may have a shape of a hole extending from the inner peripheral wall surface of the protrusion 19 defining the recess 20 to the outer peripheral wall surface of the protrusion 19, as illustrated in FIG. 7. For example, each communicating portion 21 may have a shape of a notch located near the tip of the protrusion 19, as illustrated in FIG. 8. The plurality of communicating portions 21 may have the same shape or different shapes.

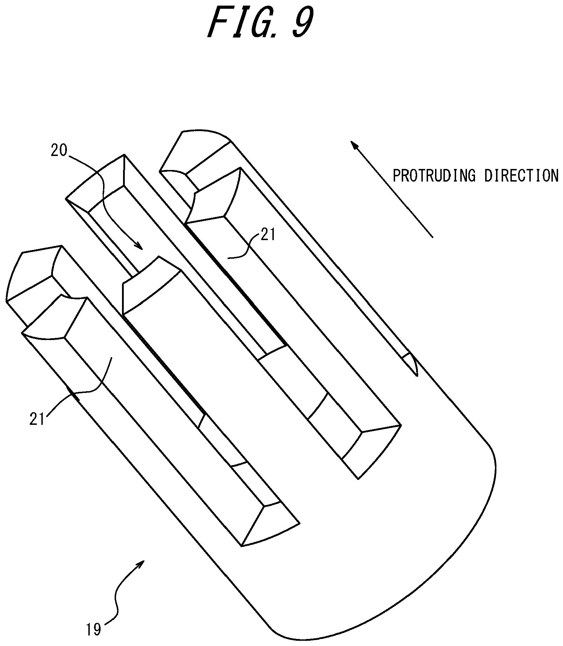

The bottom surface of the recess 20 may be farther from the tip of the protrusion 19 than a part that is farthest from the tip of the protrusion 19 from among the communicating wall surfaces defining the communicating portion 21, as illustrated in FIG. 4. Alternatively, the bottom surface of the recess 20 may be closer to the tip of the protrusion 19 than the part farthest from the tip of the protrusion 19, as illustrated in FIG. 9.

In the fixing structure 14, at least part of the outer peripheral wall surface of the protrusion 19 faces the inner peripheral wall surface defining the engaging portion 18, as illustrated in FIG. 3. In other words, in the fixing structure 14, the protrusion 19 is inserted in the engaging portion 18.

The adhesion body 17 is interposed between the engaging portion 18 and the protrusion 19, and fixes the plate-like member 15 to the housing 16. Specifically, the adhesion body 17 is a cured adhesive. Examples of the adhesive include photo-curing resin and thermosetting resin. As illustrated in FIG. 3, the adhesion body 17 is located from the recess 20 to a space between the engaging portion 18 and the protrusion 19 through the plurality of communicating portions 21. In detail, the adhesion body 17 projects from the protrusion 19 through the plurality of communicating portions 21 from the recess 20 and reaches the engaging portion 18.

A manufacturing method for the fixing structure 14 will be described below.

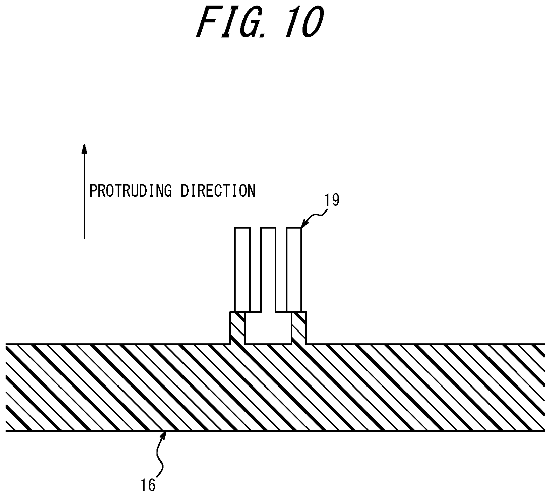

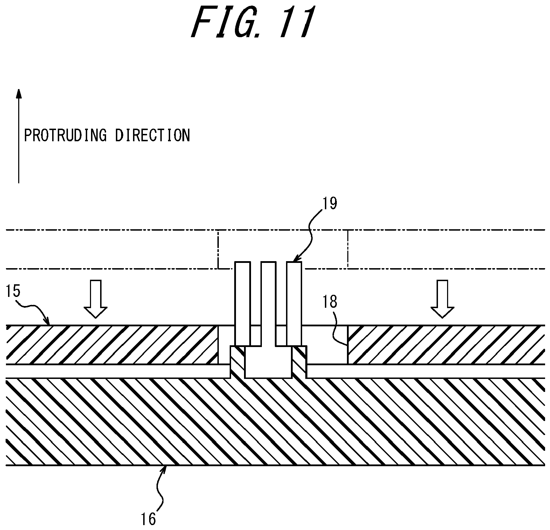

To manufacture the fixing structure 14, the housing 16 having the protrusion 19 of the foregoing configuration is supported so that the protruding direction of the protrusion 19 will be vertically upward, as illustrated in FIG. 10. For example, in a configuration in which an adhesive having high viscosity is used, the protruding direction of the protrusion 19 is not limited to vertically upward, and the housing 16 may be supported so that the protruding direction of the protrusion 19 will be a horizontal direction. After the housing 16 is supported, the plate-like member 15 of the foregoing configuration is placed in the housing 16 so that the protrusion 19 will be inserted into the engaging portion 18, as illustrated in FIG. 11. To place the plate-like member 15 in the housing 16, for example, a jig that supports the plate-like member 15 so as to be displaceable three-dimensionally is used. By inserting the protrusion 19 into the engaging portion 18, rough alignment of the plate-like member 15 in the housing 16 is carried out.

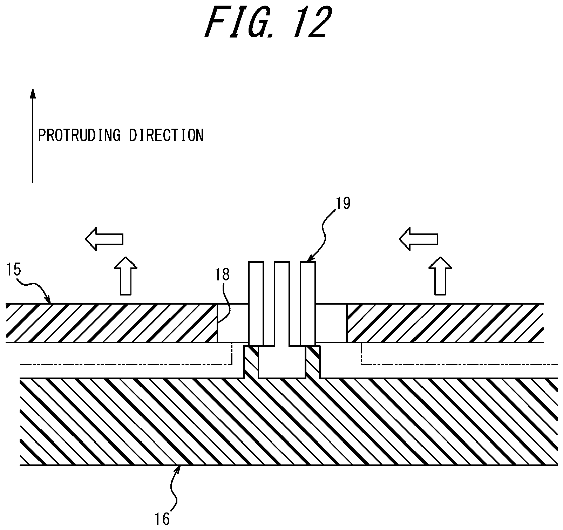

By displacing the plate-like member 15 in the protruding direction and in a direction perpendicular to the protruding direction as illustrated in FIG. 12, precise alignment of the plate-like member 15 in the housing 16 is carried out. In a configuration in which the fixing structure 14 fixes the image sensor 13 as in this embodiment, precise alignment to match the position of the light receiving surface of the image sensor 13 to the focusing position of the optical system 12 in the protruding direction of the protrusion 19 is required. Moreover, in this configuration, precise alignment to match the center of the imaging region of the image sensor 13 to the optical axis of the optical system 12 in the direction perpendicular to the protruding direction of the protrusion 19 is required. In the example in FIG. 12, the precise alignment is performed by displacing the plate-like member 15 in the protruding direction and leftward in the drawing from the position in the rough alignment (indicated by dashed-two dotted lines).

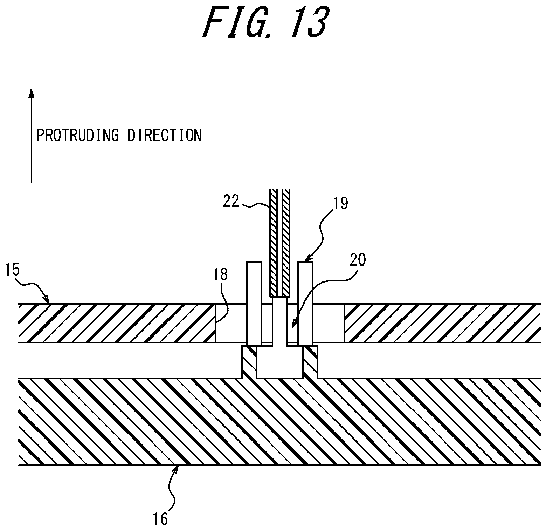

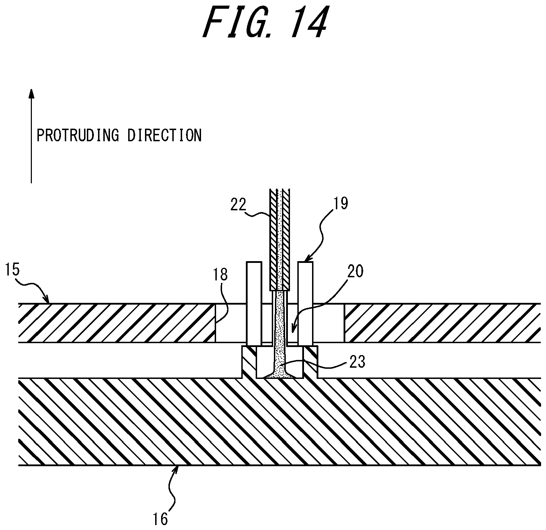

After the precise alignment, an injector 22 for an adhesive is inserted into the recess 20 of the protrusion 19, as illustrated in FIG. 13. The injector 22 may have a small-diameter inlet from which the adhesive 23 can be injected into the recess 20, like a needle. In a state in which the injector 22 is inserted in the recess 20, an adhesive 23 is discharged from the injector 22 as illustrated in FIG. 14, thus starting the injection of the adhesive 23 into the recess 20.

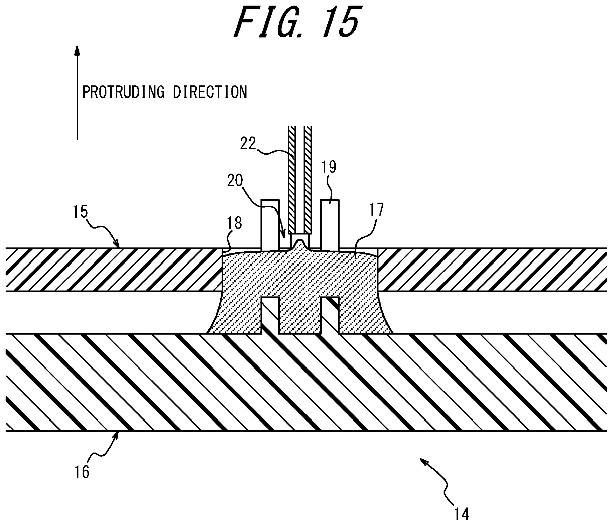

After the injection of the adhesive 23 is started, the injection of the adhesive 23 is stopped once the adhesive 23 has reached the engaging portion 18 as a result of flowing out of the recess 20 to the outer periphery of the protrusion 19 through the communicating portions 21, as illustrated in FIG. 15. After the injection is stopped, the injector 22 is extracted and removed from the recess 20, and the adhesive 23 is cured. In the case where the adhesive 23 is photo-curing resin, the adhesive 23 is irradiated with light of a wavelength for curing the resin. In the case where the adhesive 23 is thermosetting resin, the adhesive 23 is heated to the curing temperature of the resin. As a result of curing the adhesive 23, the fixing structure 14 is manufactured.

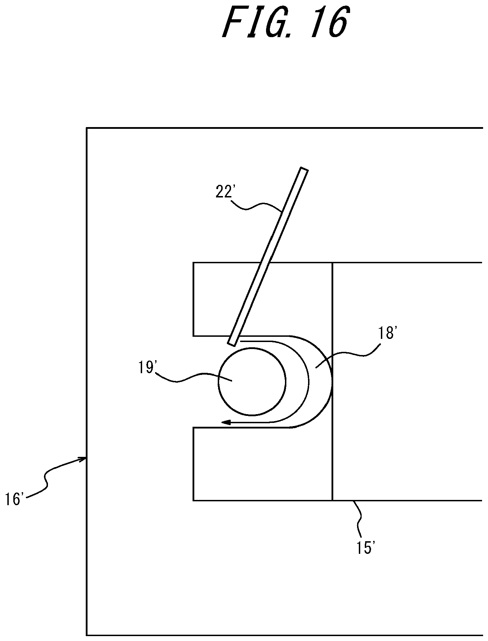

In the fixing structure 14 according to this embodiment with the foregoing configuration, the adhesion body 17 for fixing the plate-like member 15 to the housing 16 is located from the recess 20 of the protrusion 19 of the housing 16 to a space between the engaging portion 18 and the protrusion 19 through the plurality of communicating portions 21 distributed around the axis extending in the protruding direction. With such a configuration, in the fixing structure 14, the adhesion body 17 can be uniformly formed around the axis extending in the protruding direction of the protrusion 19. Since the adhesive 23 shrinks on curing, if the adhesion body 17 between the protrusion 19 and the engaging portion 18 is not uniformly formed around the axis extending in the protruding direction, there is a possibility that the plate-like member 15 deviates from the position of alignment. For example, in the fixing structure described in PTL 1, after alignment of a circuit board 15' in a housing 16', an adhesive 23 needs to be applied in the gap between a hole 18' and a protrusion 19' in the circumferential direction of the protrusion 19', as illustrated in FIG. 16. However, uniformly applying the adhesive 23 in the gap between the hole 18' and the protrusion 19' in the circumferential direction of the protrusion 19' requires high skill as, for example, the operator needs to discharge the adhesive 23 while displacing an injector 22' in the circumferential direction. Thus, alignment of high accuracy is difficult. In the fixing structure 14 of the foregoing configuration, on the other hand, the adhesion body 17 can be uniformly formed around the axis extending in the protruding direction, so that the plate-like member 15 can be aligned in the housing 16 with high accuracy.

In the fixing structure 14 according to this embodiment, the plurality of communicating portions 21 are arranged at equal intervals around the axis extending in the protruding direction. With such a configuration, in the fixing structure 14, the adhesion body 17 can be more uniformly formed around the axis extending in the protruding direction of the protrusion 19. Hence, in the fixing structure 14, the plate-like member 15 can be aligned in the housing 16 with higher accuracy.

In the fixing structure 14 according to this embodiment, the bottom surface of the recess 20 may be farther from the tip of the protrusion 19 than a part that is farthest from the tip of the protrusion 19 from among the communicating wall surfaces defining the communicating portion 21. With such a configuration, even in the case where, when manufacturing the fixing structure 14, the insertion position of the injector 22 in the recess 20 deviates from the center of the recess 20 as seen from the protruding direction, the liquid surface of the adhesive 23 can become level before it rises to the communicating portions 21. Accordingly, in the manufacture of the fixing structure 14, the adhesive 23 can be uniformly flown out through each communicating portion 21 regardless of the distance from the insertion position to the communicating portion 21. Hence, in the fixing structure 14, the adhesion body 17 can be uniformly formed around the axis extending in the protruding direction regardless of the insertion position of the injector 22 in the recess 20 in the manufacture.

In the fixing structure 14 according to this embodiment, the bottom surface of the recess 20 may be closer to the tip of the protrusion 19 than a part that is farthest from the tip of the protrusion 19 from among the communicating wall surfaces defining the communicating portion 21. With such a configuration, the amount of the adhesive 23 used in the fixing structure 14 can be reduced.

While some embodiments of the present disclosure have been described above by way of drawings and examples, various changes and modifications may be easily made by those of ordinary skill in the art based on the present disclosure.

### REFERENCE SIGNS LIST

- 10: imaging apparatus
- 11: moveable body
- 12: optical system
- 13: image sensor
- 14: fixing structure
- 15: plate-like member
- 15': circuit board
- 16, 16': housing
- 17: adhesion body
- 18: engaging portion
- 18': hole
- 19, 19': protrusion
- 20: recess
- 21: communicating portion
- 22, 22': injector
- 23: adhesive
- os: surrounding space

## Claims

1. A fixing structure (14) comprising:
a plate-like member (15) having an engaging portion (18) that includes at least one of a through hole and a notch;
a housing (16) having a protrusion (19), the protrusion (19) comprising an outer peripheral wall surface at least partly facing an inner peripheral wall surface of the plate-like member (15)defining the engaging portion (18),
**characterized in that**:
the protrusion (19) comprises a recess (20) formed from a tip thereof along a protruding direction thereof, and the protrusion (19) comprises a plurality of communicating portions (21) that communicate between the recess (20) and an outer periphery of the protrusion (19) and that are distributed around an axis extending in the protruding direction; and
an adhesion body (17) is interposed between the engaging portion (18) and the protrusion (19), and fixes the plate-like member (15) to the housing (16),
wherein the adhesion body (17) is located from the recess (20) to a space between the engaging portion (18) and the protrusion (19) through the plurality of communicating portions (21).

2. The fixing structure (14) according to claim 1, wherein the plurality of communicating portions (21) are arranged at equal intervals around the axis extending in the protruding direction.

3. The fixing structure (14) according to claim 1 or 2, wherein the plurality of communicating portions (21) have a shape of a slit extending from the tip of the protrusion (19) along the protruding direction.

4. The fixing structure (14) according to claim 1 or 2, wherein the plurality of communicating portions (21) have a shape of a hole extending from an inner peripheral wall surface defining the recess (20) to the outer peripheral wall surface.

5. The fixing structure (14) according to claim 1 or 2, wherein the plurality of communicating portions (21) have a shape of a notch located near the tip of the protrusion.

6. An electronic apparatus comprising the fixing structure (14) according to claim 1, wherein the plate like member (15) is a circuit board.

7. An imaging apparatus (10) comprising the fixing structure (14) according to any one of claims 1 to 5, wherein the plate like member (15) is a circuit board and an image sensor (13) is mounted on the circuit board.

8. A moveable body (11) comprising the imaging apparatus (10) according to claim 7.

9. A fixing structure (14) manufacturing method comprising:
supporting a housing (16) having a protrusion;
inserting the protrusion (19) into an engaging portion (18) of a plate-like member (15), the engaging portion (18) including at least one of a through hole and a notch;
performing alignment of the plate-like member (15) in the housing;
starting injection of an adhesive into a recess (20) formed in the protrusion (19) from a tip of the protrusion (19) along a protruding direction thereof;
stopping the injection of the adhesive after the adhesive has reached the engaging portion (18) as a result of flowing out of the recess (20) through a plurality of communicating portions (21) of the protrusion, the plurality of communicating portions (21) communicating between the recess (20) and an outer periphery of the protrusion (19), and being distributed around an axis extending in the protruding direction; and
curing the adhesive that has reached the engaging portion (18).

## Patentansprüche

1. Befestigungsstruktur (14), aufweisend:
ein plattenartiges Element (15), das einen Eingriffsabschnitt (18) aufweist, der mindestens eines von einem Durchgangsloch und einer Kerbe aufweist,
ein Gehäuse (16), das einen Vorsprung (19) aufweist, wobei der Vorsprung (19) eine Außenumfangswandfläche aufweist, die zumindest teilweise einer Innenumfangswandfläche des plattenartigen Elements (15) zugewandt ist, die den Eingriffsabschnitt (18) definiert,
**dadurch gekennzeichnet, dass**:
der Vorsprung (19) eine Aussparung (20) aufweist, die von einem vorderen Ende davon entlang einer Vorsprungsrichtung davon ausgebildet ist, und der Vorsprung (19) eine Mehrzahl von Kommunikationsabschnitten (21) aufweist, die zwischen der Aussparung (20) und einem Außenumfang des Vorsprungs (19) kommunizieren und die um eine sich in der Vorsprungsrichtung erstreckende Achse verteilt sind, und
ein Haftkörper (17) zwischen dem Eingriffsabschnitt (18) und dem Vorsprung (19) angeordnet ist und das plattenartige Element (15) an dem Gehäuse (16) befestigt,
wobei der Haftkörper (17) von der Aussparung (20) zu einem Raum zwischen dem Eingriffsabschnitt (18) und dem Vorsprung (19) durch die Mehrzahl von Kommunikationsabschnitten (21) hindurch angeordnet ist.

2. Befestigungsstruktur (14) gemäß Anspruch 1, wobei die Mehrzahl von Kommunikationsabschnitten (21) in gleichen Abständen um die sich in der Vorsprungsrichtung erstreckende Achse angeordnet sind.

3. Befestigungsstruktur (14) gemäß Anspruch 1 oder 2, wobei die Mehrzahl von Kommunikationsabschnitten (21) eine Form eines Schlitzes hat, der sich von dem vorderen Ende des Vorsprungs (19) entlang der Vorsprungsrichtung erstreckt.

4. Befestigungsstruktur (14) gemäß Anspruch 1 oder 2, wobei die Mehrzahl von Kommunikationsabschnitten (21) eine Form eines Lochs hat, das sich von einer Innenumfangswandfläche, die die Aussparung (20) definiert, zu der Außenumfangswandfläche erstreckt.

5. Befestigungsstruktur (14) gemäß Anspruch 1 oder 2, wobei die Mehrzahl von Kommunikationsabschnitten (21) eine Form einer Kerbe hat, die sich in der Nähe des vorderen Endes des Vorsprungs befindet.

6. Elektronische Vorrichtung, aufweisend die Befestigungsstruktur (14) gemäß Anspruch 1, wobei das plattenartige Element (15) eine Leiterplatte ist.

7. Abbildungsvorrichtung (10), aufweisend die Befestigungsstruktur (14) gemäß irgendeinem der Ansprüche 1 bis 5, wobei das plattenartige Element (15) eine Leiterplatte ist und ein Bildsensor (13) auf der Leiterplatte montiert ist.

8. Bewegbarer Körper (11), aufweisend die Abbildungsvorrichtung (10) gemäß Anspruch 7.

9. Befestigungsstruktur- (14) Herstellungsverfahren, aufweisend:
Abstützen eines Gehäuses (16), das einen Vorsprung hat,
Einsetzen des Vorsprungs (19) in einen Eingriffsabschnitt (18) eines plattenartigen Elements (15), wobei der Eingriffsabschnitt (18) mindestens eines von einem Durchgangsloch und einer Kerbe aufweist,
Durchführen einer Ausrichtung des plattenartigen Elements (15) im Gehäuse,
Beginnen eines Einspritzens eines Klebstoffs in eine in dem Vorsprung (19) ausgebildete Aussparung (20) von einem vorderen Ende des Vorsprungs (19) aus entlang einer Vorsprungsrichtung davon,
Stoppen des Einspritzens des Klebstoffs, nachdem der Klebstoff den Eingriffsabschnitt (18) als Ergebnis eines Herausströmens aus der Aussparung (20) durch eine Mehrzahl von Kommunikationsabschnitten (21) des Vorsprungs hindurch erreicht hat, wobei die Mehrzahl von Kommunikationsabschnitten (21) zwischen der Aussparung (20) und einem Außenumfang des Vorsprungs (19) kommuniziert und um eine sich in der Vorsprungsrichtung erstreckende Achse verteilt ist, und
Aushärten des Klebstoffs, der den Eingriffsabschnitt (18) erreicht hat.

## Revendications

1. Structure de fixation (14), comprenant :
un élément de type plaque (15) ayant une partie de prise (18) qui comprend au moins l'un d'un trou traversant et d'une encoche ;
un boîtier (16) ayant une saillie (19), la saillie (19) comprenant une surface de paroi périphérique extérieure au moins partiellement faisant face à une surface de paroi périphérique intérieure de l'élément de type plaque (15) définissant la partie de prise (18),
**caractérisée en ce que** :
la saillie (19) comprend un évidement (20) formé à partir d'une extrémité avant de celle-ci le long d'une direction de saillie de celle-ci, et la saillie (19) comprend une pluralité de parties de communication (21) qui communiquent entre l'évidement (20) et une périphérie extérieure de la saillie (19) et qui sont réparties autour d'un axe s'étendant dans la direction de saillie ; et
un corps d'adhésion (17) est interposé entre la partie de prise (18) et la saillie (19), et fixe l'élément de type plaque (15) au boîtier (16),
dans laquelle le corps d'adhésion (17) est situé à partir de l'évidement (20) à un espace entre la partie de prise (18) et la saillie (19) à travers la pluralité de parties de communication (21).

2. Structure de fixation (14) selon la revendication 1, dans laquelle la pluralité de parties de communication (21) sont disposées à intervalles égaux autour de l'axe s'étendant dans la direction de saillie.

3. Structure de fixation (14) selon la revendication 1 ou 2, dans laquelle la pluralité de parties de communication (21) ont une forme d'une fente s'étendant de l'extrémité avant de la saillie (19) le long de la direction de saillie.

4. Structure de fixation (14) selon la revendication 1 ou 2, dans laquelle la pluralité de parties de communication (21) ont une forme d'un trou s'étendant d'une surface de paroi périphérique intérieure définissant l'évidement (20) à la surface de paroi périphérique extérieure.

5. Structure de fixation (14) selon la revendication 1 ou 2, dans laquelle la pluralité de parties de communication (21) ont une forme d'une encoche située près de l'extrémité avant de la saillie.

6. Appareil électronique comprenant la structure de fixation (14) selon la revendication 1, dans lequel l'élément de type plaque (15) est une carte de circuit.

7. Appareil d'imagerie (10) comprenant la structure de fixation (14) selon l'une quelconque des revendications 1 à 5, dans lequel l'élément de type plaque (15) est une carte de circuit et un capteur d'image (13) est monté sur la carte de circuit.

8. Corps mobile (11) comprenant l'appareil d'imagerie (10) selon la revendication 7.

9. Procédé de fabrication d'une structure de fixation (14), comprenant :
le support d'un boîtier (16) présentant une saillie ;
l'insertion de la saillie (19) dans une partie de prise (18) d'un élément de type plaque (15), la partie de prise (18) comprenant au moins l'un d'un trou traversant et d'une encoche ;
l'exécution d'un alignement de l'élément de type plaque (15) dans le boîtier ;
le commencement d'une injection d'un adhésif dans un évidement (20) formé dans la saillie (19) à partir d'une extrémité avant de la saillie (19) le long d'une direction de saillie de celle-ci ;
l'arrêt de l'injection de l'adhésif après que l'adhésif a atteint la partie de prise (18) à la suite d'un écoulement en dehors de l'évidement (20) à travers une pluralité de parties de communication (21) de la saillie, la pluralité de parties de communication (21) communiquant entre l'évidement (20) et une périphérie extérieure de la saillie (19), et étant réparties autour d'un axe s'étendant dans la direction de la saillie ; et
le durcissement de l'adhésif qui a atteint la partie de prise (18).
